# EUROPEAN PATENT APPLICATION

(11) **EP 2 722 991 A1**
(43) Date of publication of application: **23.04.2014**
(21) Application number: 13185793.0
(22) Date of filing: 24.09.2013
(51) Int. Cl.: H03M 7/30, G06F 9/445

(54) **Data decompression method for a controller equipped with limited ram**

(30) Priority: 16.10.2012 US 201213652573
(71) Applicant: Delphi Technologies, Inc., Troy MI 48007 (US)
(72) Inventor: Boring, Jeffrey Todd, Kokomo, IN Indiana 46901 (US)
(74) Representative: Neill, Andrew Peter

(57) **Abstract**

A method (200) of operating a controller to decompress a compressed data file stored on a host computer, and store the resulting uncompressed data in a flash memory. The processor loads (205) compressed data into random access memory (RAM) until a predetermined amount of compressed data is present in the RAM (215). The controller then decompresses (220) compressed data retrieved from the RAM until a decompressed amount of decompressed data equals a block size corresponding to a minimum modulus size of the flash memory, where the minimum size block of data that can be written to the flash memory because of the design of the flash memory. The controller then transfers the block of decompressed data to the flash memory (245). These steps are repeated in a coordinated fashion until the entire compressed data file has been downloaded from the host computer, decompressed by the controller, and stored in the flash memory.

## Description

### TECHNICAL FIELD OF INVENTION

This disclosure generally relates to programming a controller with software or data from a host computer, and more particularly relates to a way to decompress a data file using a controller that does not have enough random access memory (RAM) to hold the entire compressed data file while decompressing.

### BACKGROUND OF INVENTION

Many devices people use every day have embedded controllers. Examples of such devices include, but are not limited to, automobiles, global position satellite (GPS) navigation units, smart phones, refrigerators, washing machines, etc. Typically, the controller in these devices are equipped with random access memory (RAM) used by a processor (e.g. microprocessor) in the controller for temporary storage as the contents of RAM are lost when power is removed from the controller, and non-volatile memory, for example flash memory, for storing a data file such as a software program or calibration data used by the processor when executing the software program. It is known to program or download an embedded controller with software or data updates via a host computer such as a laptop type personal computer. Such a download may be part of a manufacturing process when building the device, or part of a service/maintenance process after the device has been sold to a consumer.

As the devices become more sophisticated to provide consumers with more features, the size of the data files downloaded increase, and so the time necessary to perform these downloads increases. Limitations on communication speed between the host computer and the controller are such that overall download efficiency is improved (i.e. - download time is decreased) if the data file is compressed, communicated to the controller in compressed form, and then decompressed by the controller before storing the decompressed data file in the flash memory. However, it is often the case that the controller does not have enough RAM to receive the entire compressed data file. To overcome this problem, it has been proposed to communicate the data file from the host computer to the controller in the form of numerous smaller data files that are sized so the RAM can temporally store each smaller data file while the processor decompresses each data file after it received into the RAM. However, this approach is slower (i.e. less time efficient) than desired when the size of the original data file is such that hundreds of smaller data files are required to complete the data download.

### SUMMARY OF THE INVENTION

In accordance with one embodiment, a method of operating a controller to decompress a compressed data file stored on a host computer, and store the resulting uncompressed data in a flash memory is provided. The process of decompressing is such that an unknown amount of uncompressed data arises from a known amount of compressed data. The controller includes a random access memory (RAM) configured to receive compressed data from the host computer and accumulate uncompressed data as the compressed data is decompressed, wherein the flash memory is configured to store a block of decompressed data that has accumulated in the RAM. The block has a block size that corresponds to an integer multiple of a minimum modulus size of the flash memory. The method includes the step of loading compressed data received from the host computer into the RAM until a predetermined amount of compressed data is present in the RAM, or an end of file of the compressed data file is detected. The method also includes the step of then decompressing compressed data retrieved from the RAM until a decompressed amount of decompressed data equals the block size, or all compressed data in RAM is decompressed. The method also includes the step of then transferring the block of decompressed data to the flash memory if the decompressed amount of decompressed data equals the block size. The method also includes the step of repeating the loading and decompressing steps if the amount of decompressed data is less than the block size and the end of file has not been detected. The method also includes the step of transferring the decompressed data to the flash memory if the amount of decompressed data is less than the block size and the end of file has been detected.

In another embodiment, a controller configured to receive a compressed data file from a host computer, and decompress said compressed data file for use by the controller is provided. The controller includes a random access memory (RAM), a flash memory, and a processor. The RAM is configured to receive compressed data from the host computer and accumulate uncompressed data as the compressed data is decompressed. The data is decompressed in a manner such that an unknown amount of uncompressed data arises from a known amount of compressed data. The flash memory configured to store a block of decompressed data that has accumulated in the RAM. The block has a block size that corresponds to an integer multiple of a minimum modulus size of the flash memory. The processor is configured to load compressed data received from the host computer into the RAM until a predetermined amount of compressed data is present in the RAM, or an end of file (EOF) of the compressed data file is detected. The process is further configured to decompress compressed data retrieved from the RAM until a decompressed amount of decompressed data equals the block size, or all compressed data in RAM is decompressed. The process is further configured to transfer the block of decompressed data to the flash memory if the decompressed amount of decompressed data equals the block size. The process is further configured to repeat the load and decompress steps if the amount of decompressed data is less than the block size and the end of file has not been detected. The process is further configured to transfer the decompressed data to the flash memory if the amount of decompressed data is less than the block size and the end of file has been detected.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is diagram of a system for updating software on a controller in accordance with one embodiment;
Fig. 2 is a flowchart of a method of updating software on the controller of Fig. 1 in accordance with one embodiment;
Fig. 3 is a flowchart of a method of decompressing software on the controller of Fig. 1 in accordance with one embodiment;
Fig. 4 is a flowchart of a method of updating software on the controller of Fig. 1 in accordance with one embodiment;
Fig. 5 is a flowchart of a method of operating a host computer of the system of Fig. 1 accordance with one embodiment;
Fig. 6 is a flowchart of a method of operating the controller on the system of Fig. 1 in accordance with one embodiment; and
Fig. 7 is a flowchart of a method of operating the controller on the system of Fig. 1 in accordance with one embodiment.

### DETAILED DESCRIPTION

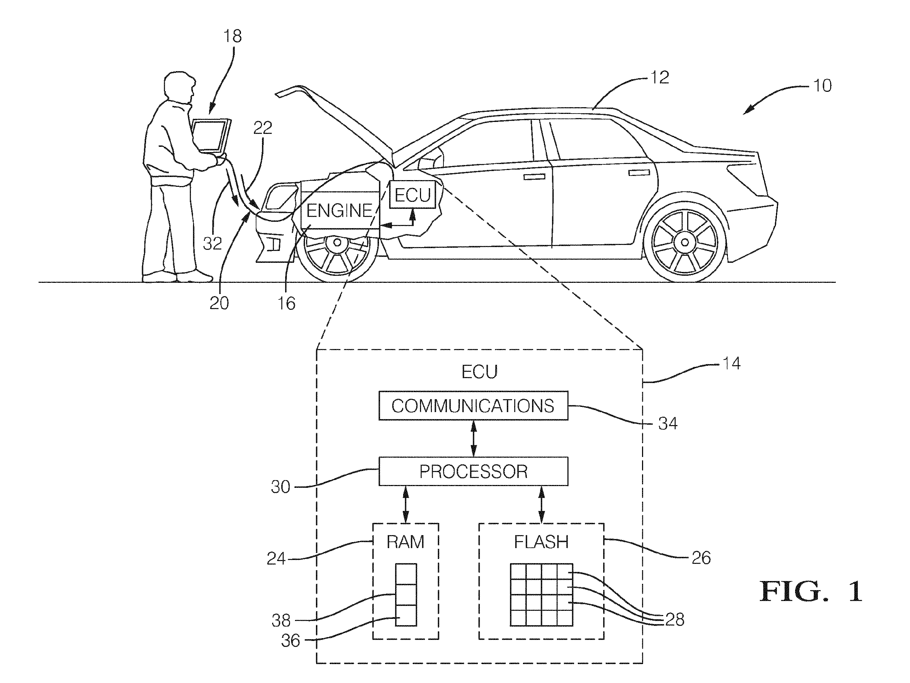

Fig. 1 illustrates a non-limiting example of a software update system, hereafter the system 10. In this example, a vehicle 12 is equipped with an engine control unit (ECU), hereafter the controller 14, configured to control an engine 16. Other non-limiting examples include controllers for controlling air conditioning, suspension systems, occupant protection such as air bags, and navigations systems. Non-limiting examples of non-automotive controllers include smartphones, tablets, household appliances, entertainment systems, and building security systems. It will become apparent in the description that follows that the teachings presented herein are not limited to automotive applications.

If the controller 14 is to receive updated software or an updated engine calibration data, the controller 14 may be coupled to a host computer 18, for example a laptop personal computer. The connection between the controller 14 and the host computer 18 may be by way of a communication cable 20 that may be connected to an in-vehicle communication network (not shown), for example, a communication area network (CAN) bus. Alternatively, the communication between the controller 14 and the host computer 18 may be wireless as will be recognized by those in the art. Applicants discovered that the time required for transferring a compressed data file or compressed data 22 from the host computer 18 to the controller 14, and then use the controller 14 to decompress the compressed data 22 is less than the time to transfer the same information in decompressed form as an uncompressed or decompressed data file. In other words, it's faster to download the compressed data file and then decompress when compared to starting with a decompressed data file and sending the entire decompressed data file over the communication cable 20 to, for example, the CAN bus.

As such, the controller 14 is generally configured to receive a compressed data 22 from the host computer 18, and then decompress the compressed data 22 for use by the controller 14. The controller 14 includes a random access memory (RAM) 24 configured to receive data in the compressed data file (i.e. the compressed data 22) from the host computer 18 and accumulate uncompressed data as the compressed data is decompressed. As used herein, RAM refers to a type of memory that is byte-wise or bit-wise addressable, in contrast to types of memory that must be written to in blocks such as eight byte blocks. Also, as used herein, RAM refers to a type of memory that does not preserve the data stored in the RAM 24 when electrical power is removed from the controller 14 or the RAM 24, i.e. - volatile memory. It should also be noted that the amount of uncompressed data that arises from decompressing a known amount of compressed data is not fixed, i.e. is unknown. For example, a kilobyte (1024 bytes) of compressed data may generate from 1460 bytes to 2560 bytes of data when decompressed.

The controller 14 also includes a flash memory 26 configured to store a block 28, or a plurality of blocks, of decompressed data that has accumulated in the RAM 24. In general, the block 28 has a block size that corresponds to an integer multiple of a minimum modulus size of the flash memory 26, where the minimum modulus size is the minimum amount of data that can be written to the flash memory 26. As used herein, flash memory refers to a type of memory that preserves the data stored in the flash memory 26 when electrical power is removed from the controller 14 or the flash memory 26, i.e. - non-volatile memory. As is known by those skilled in the art, flash memory often requires that data be written in multiple byte blocks (i.e. the block 28), referred to herein as the minimum modulus size. For example, the minimum modulus size of the flash memory 26 may be eight bytes (8 bytes) or some integer multiple of eight bytes such sixteen bytes or thirty-two bytes, and so data must be written to the flash memory 26 in quantities characterized as integer multiples of a minimum modulus size of the flash memory 26.

The controller 14 also includes a processor 30 configured to load the compressed data 22 from the host computer 18 into the RAM 24. Loading the compressed data 22 into the RAM 24 may be by way of a communications block 34 that may include, for example, and CAN communications circuit, or a wireless transceiver configured for BLUETOOTH® or WI-FI® wireless communications. The loading process continues until either a predetermined amount of compressed data is present in the RAM 24, or an indication that an end of file (EOF) 32 of the compressed data file is detected. This avoids overloading or overflowing the RAM 24. The RAM 24 may be partitioned into portions reserved for specific use by the processor 30. For example, the RAM 24 may include a compressed data portion 36 designated for storing the compressed data 22 received by the controller 14. It should be appreciated that the teachings presented herein are particularly advantageous when the size (data wise, not physical) of the compressed data file is larger than the size of the RAM available for the compressed data portion 36.

Once the compressed data portion 36 is full, or is filled with a predetermined amount of compressed data, the controller 14, or the processor 30, may stop downloading the compressed data 22 and start decompressing the compressed data 22 stored in the compressed data portion 36 of the RAM 24. It is recognized that various steps could be performed simultaneously if a multiple core type processor is used. Accordingly, the RAM 24 may also be partitioned to define a decompressed data portion 38 of the RAM 24 to accumulate or temporarily store uncompressed data arising from decompressing the compressed data 22. The decompressing of the compressed data 22 may continue until the amount of decompressed data stored in the decompressed data portion 38 equals the block size of the block 28, or all of the compressed data 22 stored in the RAM 25 is decompressed because there is insufficient compressed data to generate an entire block of uncompressed data. The advantageous interactions of starting and stopping the loading of the compressed data 22; starting and stopping the decompressing of the compressed data 22; and starting and stopping the transfer of uncompressed data to the block 28 in the flash memory 26 is describe in more detail below. The processor 30 is configured to control the interaction of these various processes. It is the cooperation of the processor 30 with the host computer 18 that provides for a time efficient download of the compressed data 22 into the flash memory 26.

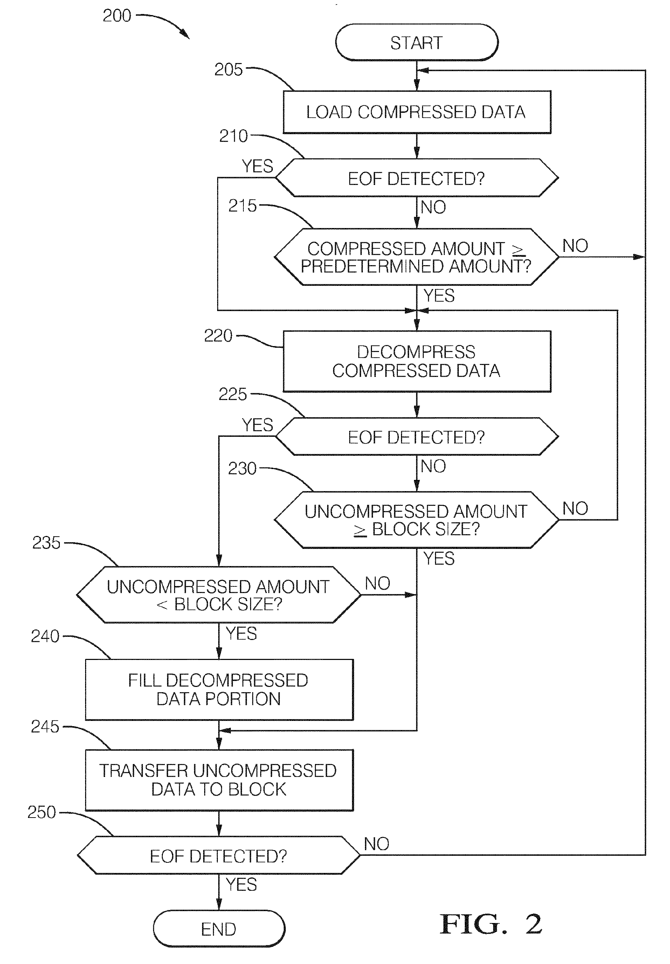

Fig. 2 illustrates a non-limiting example of a method 200 of operating the controller 14, or the processor 30, to decompress a compressed data file stored on a host computer 18, and store the resulting uncompressed data in the flash memory 26. In contrast to compression/decompression algorithms where the compression or decompression ratios are known, the method 200 is suitable for use when an unknown amount of uncompressed data arises from a known amount of the compressed data 22.

Step 205, LOAD COMPRESSED DATA, may include the controller 14 or the processor 30 sending a request for data to the host computer 18 followed by the controller 14 loading the compressed data 22 from the host computer 18 into the RAM 24. If the amount or size of the compressed data 22 is predetermined so that the amount downloaded fills the compressed data portion 36, then optional steps 210 and 215 may be omitted. If the size of the compressed data 22 read from the file is smaller than the compressed data portion 36, for example one byte, then following each occurrence of step 205, the optional steps 210 and 215 may be executed, followed by repeating step 205 until one of the tests in steps 210 or 215 change the logic route. The optional steps 210 and 215 may be executed several times before the predetermined block size of data is met. If the data is read from the file is equal to the size of the predetermined block size, then the operation will fall through to step 220 until the last portion of the file is read. This last portion may be less than the predetermined block size but will result in an EOF. This will force execution to continue to step 220 with data less than the predetermined block size.

Step 210, EOF DETECTED?, may include examining the contents of the compressed data 22 to see if the EOF 32 is included in the compressed data 22, thereby indicating that there is no more compressed data available. Alternatively, the detection of the EOF 32 may be don by the host computer 18 and the detection may be communicated to the controller 14 to control the downloading of data to the controller 14. If the EOF 32 is detected, the method 200 proceeds to step 220 to initiate decompressing the compressed data 22. By way of example and not limitation, an EOF flag may be set by the processor 30 so the EOF flag can be checked by steps 225 and 250 instead of repeating the examination of data looking for the EOF 32.

Step 215, COMPRESSED AMOUNT ≥ PREDETERMINED AMOUNT?, may include determining the amount of compressed data present in the compressed data portion 36, and directing the method 200 to execute step 220 if returning to step 205 would likely overflow or overload the compressed data portion 36. In summary, steps 205, 210, and 215 cooperate to put a suitable amount compressed data into the RAM 24, while providing a mechanism to exit the loading process if the EOF 32 is detected or a suitable amount of compressed data has been put into the RAM 24.

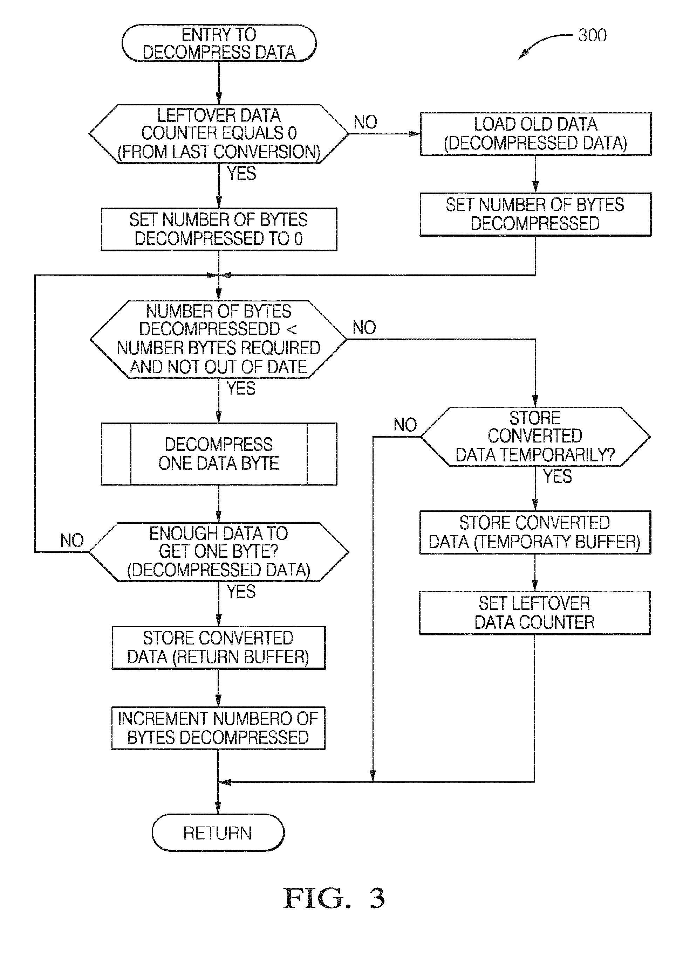

Step 220, DECOMPRESS COMPRESSED DATA, may include decompressing compressed data retrieved from the RAM 24. Fig. 3 illustrates a non-limiting example of a method 300 for decompressing data. It is anticipated that the decompression process may lead to instances of whole bytes of compressed or uncompressed data being divided into partial bytes present in either the compressed data portion 36 and the uncompressed data portion 38. As such, while Fig. 3 suggests that data is processed byte-wise, it is anticipated that data may need to be processed bit-wise, as will be recognized by those skilled in the art. The 'Decompress One Data Byte' step may be based on any of many known compression/decompression algorithms, for example a Lempel-Ziv-Storer-Szymanski (LZSS) compression and decompression algorithm. Fig. 3 is described in more detail following the description of Fig. 2

Step 225, EOF DETECTED?, may include exiting the decompressing loop defined by steps 220 - 230 because all compressed data in RAM is decompressed.

Step 230, UNCOMPRESSED AMOUNT ≥ BLOCK SIZE?, may include determining if the decompressed amount of decompressed data equals the block size of the block 28. When the amount of uncompressed data present in the RAM 24 is at least as large as the block 28, the method 200 may initiate transferring decompressed data to the block 28 of the flash memory.

Step 235, UNCOMPRESSED AMOUNT < BLOCK SIZE?, may include determining if the amount of decompressed data is less than the block size of the block 28. If the method 200 is preparing to transfer uncompressed data to the flash memory 26, but the amount of uncompressed data is less than the block size because, for example, there is no more compressed data to decompress, steps may be necessary to assure that what is transferred corresponds to the block size.

Step 240, FILL DECOMPRESSED DATA PORTION, may include filling the decompressed data portion with null data in preparation to transferring the block to the flash memory. As used herein, null data may be all zeros, or all ones, or a pattern of data that would be recognized by the controller 14 as being empty memory. In other words, corresponding to a portion of a blank page.

Step 245, TRANSFER UNCOMPRESSED DATA TO BLOCK, may include the controller 14 transferring a block sized amount of uncompressed data from the uncompressed data portion 38 to a block 28 in the flash memory 26.

Step 250, EOF DETECTED?, may include determining that the EOF 32 is present in the transferred uncompressed data, or determining that a EOF flag has been set by the processor 30, and exiting the method 200 if the EOF is detected. If NO, the method 200 returns to step 205 to load another packet of the compressed data 22 into the RAM, and the process of decompressing and transferring is repeated.

Fig. 3 illustrates a non-limiting example of a method 300 for decompressing data. In the description that follows, each step in the method is described in reference to the each step by the text in each step, where the method 300 may be characterized as a subroutine called by the method 200.

LEFTOVER DATA COUNTER EQUALS 0 (FROM LAST CONVERSION) - Check to see if there is data leftover from a previous, incomplete decompression request. This can happen when the caller requests more data than is available to be decompressed from the buffer. A counter indicates if this has happened. This value is equal to zero when the routine was able to return the number of bytes requested by the caller during the previous decompression request. If the counter is not equal to zero, then the code must load the data left over from the previous conversion (stored in a temporary buffer) and set a conversion counter (tells how many bytes have been decompressed) to the same value as the number of bytes that were leftover. This is done in the two process boxes listed below.

LOAD OLD DATA (DECOMPRESSED DATA) - Move the leftover data from the previous conversion into the buffer holding the bytes that have been decompressed and ready to be returned to the caller, i.e. the method or routine calling this subroutine, the method 300.

SET NUMBER OF BYTES DECOMPRESSED - Set a conversion counter (tells how many bytes have been decompressed) to the number of bytes that were leftover.

SET NUMBER OF BYTES DECOMPRESSED TO 0 - Initializes the counter that tells how many bytes have been decompressed.

NUMBER BYTES DECOMPRESSED < NUMBER BYTES REQUESTED? - If the routine has not decompressed the number of bytes that the caller requested, the code execution stays in this loop until it does or it runs out of data.

DECOMPRESS ONE DATA BYTE - This subroutine returns one decompressed byte or an error indicating that more data is needed in the data buffer. The 'Decompress One Data Byte' step may be based on any of many known compression/decompression algorithms, for example a Lempel-Ziv-Storer-Szymanski (LZSS) compression and decompression algorithm.

ENOUGH DATA TO GET ONE BYTE (DECOMPRESSED DATA)? - Checks for a successful decompression of one byte of data.

STORE CONVERTED DATA (RETURN BUFFER) - The converted data is stored in a buffer that will return the data to the caller.

INCREMENTED NUMBER OF BYTES DECOMPRESSED - The number of bytes decompressed is incremented to reflect the total number of bytes decompressed during this request.

STORE CONVERTED DATA TEMPORARILY? - If the total number of bytes requested cannot be met, then bytes that have been decompressed must be stored so they can be recalled on the next conversion request (after the data buffer is loaded with more data).

STORE CONVERTED DATA (TEMPORARY BUFFER) - The decompressed data bytes are stored in a temporary data buffer so they can be recovered later.

SET LEFTOVER DATA COUNTER - The number of bytes stored in the temporary data buffer is stored in counter so it also can be recalled later.

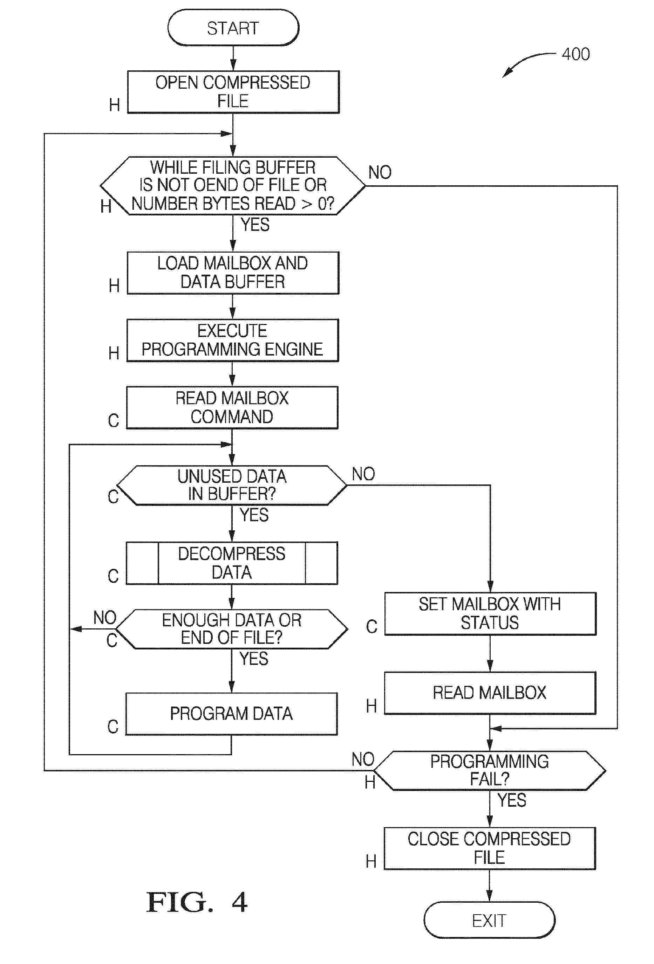

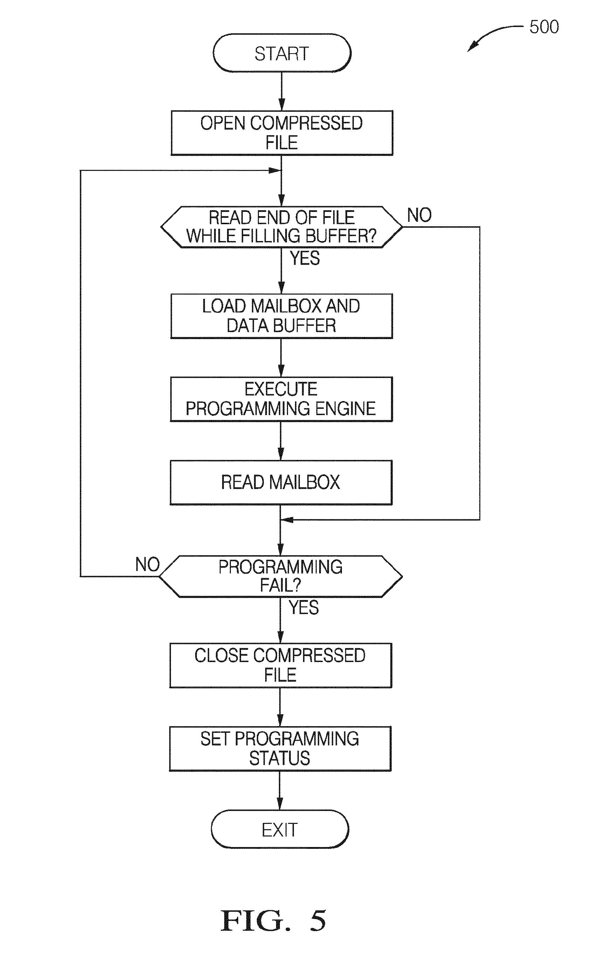

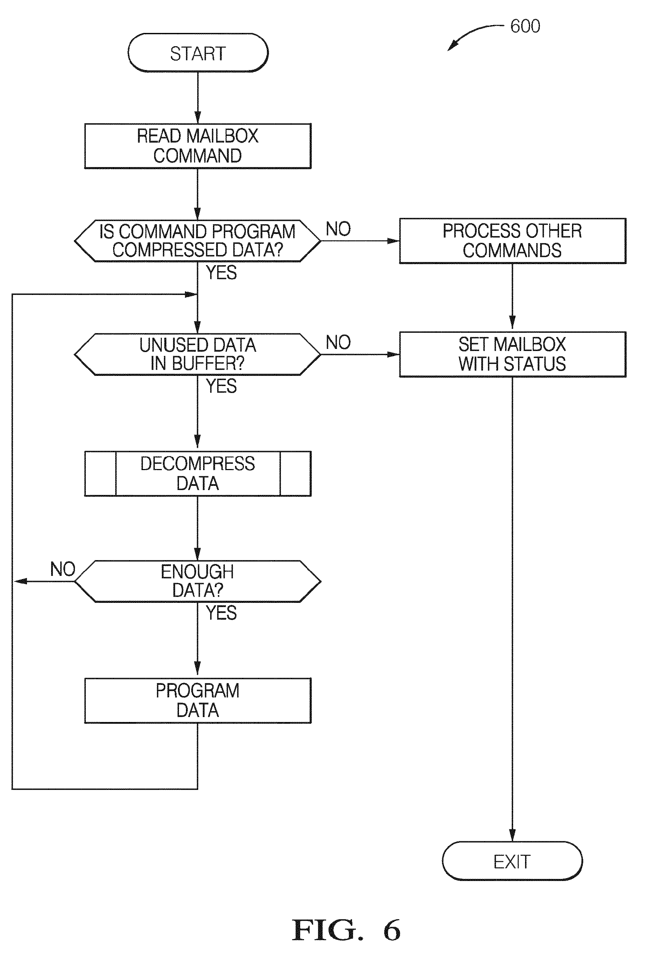

Figs. 4-6 illustrate a non-limiting example of a method 400 for a controller 14 to decompress a compressed data file stored on a host computer 18, and store the resulting uncompressed data in the flash memory 26. Each step in Fig. 4 is labeled with either an 'H' or a 'C' to indicate if the step is carried out by the host computer 18 (H) or the controller 14 (C). Fig. 5 and 6 provide more details of a method 500 of operating the host computer 18 and a method 600 of operating the controller 14. In the description that follows, each step in the methods 400, 500, and 600 are described in reference to the each step by the text in each step.

The following descriptions are given with regard to the steps marked 'H' in Fig. 4, and the steps illustrated in Fig. 5.

OPEN COMPRESSED FILE - Open the compressed file that will be transferred to the micro-controller.

READ END OF FILE WHILE FILLING BUFFER - Read data from the file one line at a time to fill a small buffer with data to send to the micro-controller (only a small part of the file will fit in the RAM buffer). The RAM buffer is a volatile memory storage device (the data is lost after the micro-processor powers down).

LOAD MAIL BOX AND DATA BUFFER - A memory location in the micro-controller's RAM is designated as the mailbox. Command information is written to this area. This command data will tell the code running on the micro-controller what task to perform. In this case it will instruct the code to program FLASH using compressed data in the data buffer. FLASH data is non-volatile data (data remains after the micro-processor power down). The mailbox will also hold data that indicates how many bytes of data will be in the data buffer. The data buffer is loaded with the data read from the compressed file above.

EXECUTE PROGRAMMING ENGINE - The micro-controller code is then executed. The code in the micro-controller will read the mailbox data and complete the command. The code on the micro-controller will then load the mail box with the result status.

READ MAIL BOX - The mailbox is read to get the results of the execution of the command.

PROGRAMMING FAIL? - If the programming operation failed, the program will drop out of the loop. If programming passed, it jumps back to the top of the loop to process more data until the end of the file is reached.

CLOSE COMPRESSED FILE - The file is close to free the pointer to the file.

SET PROGRAMMING STATUS - The status of the programming operation is stored to be returned to the calling application.

The following descriptions are given with regard to the steps marked 'C' in Fig. 4, and the steps illustrated in Fig. 6.

READ MAILBOX - Load the command from the mailbox

IS COMMAND PROGRAM COMPRESSED DATA? - If the command in the mail box is to program using the compressed data, then the code will begin processing the data. If the command is not, then it will jump to the routine that corresponds to the task requested.

PROCESS OTHER COMMANDS - The code jumps to tasks for the other commands.

UNUSED DATA IN BUFFER? - Check to see if the data buffer holds data that needs to be decompressed.

DECOMPRESS DATA - Compressed data is read from the data buffer and used to produce a fixed number of decompressed data bytes. This fixed number is determined using the minimum size of data that must be programmed at one time (normally on an 8, 16, 32, or 64 bye boundary depending on FLASH technology). Larger sizes can be use, but must be a modulus of the minimum size while remaining small enough to fit in the available RAM. When there is not enough data in the data buffer to produce the number of bytes requested, the routine will return and error indicating that it needs more data to complete the request. This tells the caller to load more compressed data into the buffer and call the routine again. The routine will store the data bytes that were decompressed during the incomplete decompression request and return them on the next conversion request after the data buffer is loaded with more compressed data (no lost data for incomplete decompressions).

ENOUGH DATA? - The result of the decompress subroutine is checked. If there were enough data to complete the conversion the code will continue to the program data section. If there was not enough data, the program will exit with that error.

PROGRAM DATA - Data that was decompressed is programmed into the FLASH device.

SET MAIL BOX WITH STATUS - Load the mail box with the status and exit. Possible status would be FAILED Programming, OUT OF DATA, and PROGAMMED ALL DATA (no incomplete decompressions).

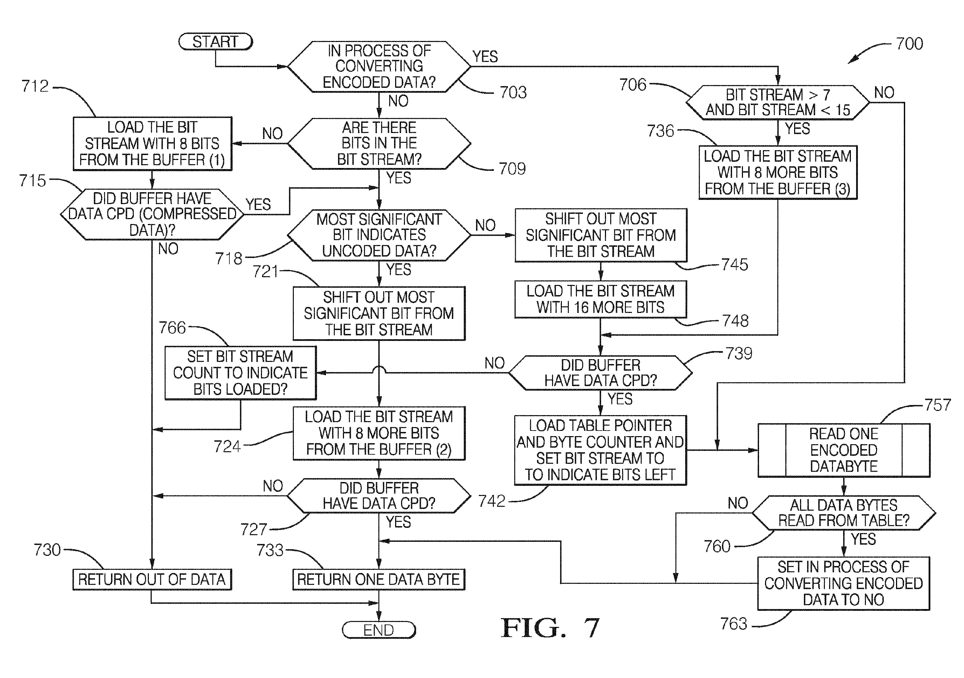

Fig. 7 illustrates a non-limiting example of a method 700 (i.e. a subroutine) for a controller 14 to decompress the compressed data stored in compressed data portion 36 of the RAM 24, and store the resulting uncompressed data in uncompressed data portion 38 of the RAM 24. As the amount of decompressed data arising from decompressing compressed data is uncertain, the method 700 provides for the process of decompressing to be terminated when a bit stream is depleted of compressed data, and restarted when the bit stream is full of compressed data. In the description that follows, each step in the method 700 is described in reference to text in each step shown in the drawing.

Step 703, IN PROCESS OF CONVERTING ENCODED DATA?, may include determining if encoded data is in the process of being converted. There are two types of data found in compressed data, uncoded and encoded. Uncoded data is not compressed and will be larger in size as compared to data not being part of a compressed format. The encoded data is the portion of the compressed data format than has been compressed. If YES, i.e. if decompressing encoded data or creating the instructions used to decompress encoded data is being performed, the logic route goes to Step 706, "BIT STREAM > 7 AND BIT STREAM < 15", which is described in more detail below following the description of step 733.

Step 709, ARE THERE BITS IN THE BIT STREAM?, may include checking if a bit stream buffer was out of data while preparing for a bit test to determine what type of data needs to be processed next. The method of compression involves working with a bit stream of data and opposed to byte level operations. If the routine was out of data, then logic route proceeds to step 712.

Step 712, LOAD THE BIT STREAM WITH 8 BITS (1), may include loading data from the compressed data portion 36 into a bit stream buffer (not shown) for subsequent processing. By way of example and not limitation, step 712 may include loading eight more bits of data so the eight bits of instruction needed to decompress encoded data will be complete. At least one bit is needed in the bit stream to detect uncoded or encoded data. The method of compression involves working with a bit stream of data and opposed to byte level operations.

Step 715, DID DATA BUFFER HAVE DATA (Compressed data)?, may include determining if the routine was successful in moving data stored in the buffer for the compressed data portion 36 to the bit stream.

Step 718, MOST SIGNIFICANT BIT INDICATES UNCODED DATA?, may include determining if the most significant data bit indicates that the following data is uncoded, the routine proceeds to process one byte of uncoded data at step 724. If the bit indicates encoded data, the bit stream will need sixteen bits of data beyond the on bit used to detect uncoded vs. encoded. This will be loaded at step 748.

Step 721, SHIFT OUT MOST SIGNIFICANT BIT FROM THE BIT STREAM, may include removing the bit that indicates uncoded vs. encoded from the bit stream. This step serves the same function as step 745.

Step 724, LOAD THE BIT STREAM WITH 8 MORE BITS (2), may include loading The Bit Stream with eight more bits of data. The next eight bits in the stream is the uncoded byte of data to return.

Step 727, DID BUFFER HAVE DATA (CPD (Compressed Data)), may include determining if loading data from the compressed data portion 36 into a bit stream was successful.

Step 730, RETURN ONE DATA BYTE, may include returning the next eight bits in the stream.

Step 733, RETURN OUT OF DATA, may include returning and error message indicating the buffer holding compressed data is empty. This pate is taken because the routine was out of data while creating the instruction to decompress encoded data or return uncoded data.

Step 706, BIT STREAM > 7 AND BIT STREAM < 15?, may include determining if the routine ran out of data while creating the sixteen bits of instruction needed to decompress encoded data. If it did, then eight more bits will be loaded at step 736.

Step 736, LOAD THE BIT STREAM WITH 8 MORE BITS (3), may include loading eight more bits needed to complete the instructions needed to decompress encoded data as sixteen bits are required in the bit stream.

Step 739, DID BUFFER HAVE DATA (COMPRESSED DATA), may include determining if the step of loading data from the compressed data portion 36 into a bit stream was successful.

Step 742, LOAD TABLE POINTER AND BYTE COUNTER AND SET BIT STREAM TO INDICATE BITS LEFT, may include loading the message needed to decompress encoded data and setting the indicator to show that the complete instruction has been created. The compressed data may be held in a table of data. A pointer and byte counter (represented by the sixteen bits of encoded data) may be used to read the data string from the table. Update the counter that indicates number of loaded in the bit stream.

Step 745, SHIFT OUT MOSTE SIGNIFICANT BIT FROM THE BIT STREAM, may include removing the bit that indicates uncoded vs. encoded from the bit stream.

Step 748, LOAD THE BIT STREAM WITH 16 MORE BITS, may include loading sixteen more bits needed to complete the instructions needed to decompress encoded data. It should be appreciated that it takes 16 bits of data to build the pointer and byte count needed to read the compressed data from the table.

Step 757, READ ONE ENCODED DATA BYTE, may include using the instructions to read (decompress) one byte of data from a lookup table. This lookup table is a table of recurring data bytes that is instrumental in compressing data.

Step 760, ALL BYTES READ FROM TABLE?, may include determining if all compressed bytes for the current instruction have been extracted.

Step 763, SET IN PROCESS OF CONVERTING ENCODED DATA TO NO?, may include indicating a completion of the current decompression instruction

Step 766, SET BIT STREAM COUNT TO INDICATE BITS LOADED?, may include indicating that an incomplete decompression instruction loaded.

Accordingly, a system 10, a controller 14 for the system 10 and a method 200, 300, 400, 500, 600, and 700 of operating the controller 14 to decompress a compressed data file stored on the host computer 18, and store the resulting uncompressed data in the flash memory 26 is provided. The system, controller, and methods provide a way to update software or data on the controller 14 faster than prior art methods.

While this invention has been described in terms of the preferred embodiments thereof, it is not intended to be so limited, but rather only to the extent set forth in the claims that follow.

## Claims

1. A method (200) of operating a controller (14) to decompress a compressed data (22) file stored on a host computer (18), and store the resulting uncompressed data in a flash memory (26), wherein an unknown amount of uncompressed data arises from a known amount of compressed data (22), wherein the controller (14) includes a random access memory (RAM) (24) configured to receive compressed data (22) from the host computer (18) and accumulate uncompressed data as the compressed data (22) is decompressed, wherein the flash memory (26) is configured to store a block (28) of decompressed data that has accumulated in the RAM (24), and wherein the block (28) has a block size that corresponds to an integer multiple of a minimum modulus size of the flash memory (26), said method (200) comprising:
loading (205) compressed data (22) received from the host computer (18) into the RAM (24) until a predetermined amount of compressed data (22) is present in the RAM (24), or an end of file of the compressed data (22) file is detected; then
decompressing (220) compressed data (22) retrieved from the RAM (24) until a decompressed amount of decompressed data equals the block size, or all compressed data (22) in RAM (24) is decompressed; then
if (230) the decompressed amount of decompressed data equals the block size, transferring (245) the block (28) of decompressed data to the flash memory (26);
if (235) the amount of decompressed data is less than the block size and the end of file has not been detected (225), repeating the loading (205) and decompressing (220) steps ; and
if the amount of decompressed data is less than the block size and the end of file has been detected (225), transferring (245) the decompressed data to the flash memory (26).

2. The method (200) in accordance with claim 1, wherein the RAM (24) is partitioned to define at least a compressed data portion (36) and a decompressed data portion (38) of the RAM (24).

3. The method (200) in accordance with claim 2, wherein the compressed data (22) file is larger than the compressed data portion (36).

4. The method (200) in accordance with claim 2, wherein the step (205) of transferring the decompressed data to the flash memory (26) when the amount of decompressed data is less than the block size includes filling (240) the decompressed data portion (38) with null data prior to transferring the block (28) to the flash memory (26).

5. The method (200) in accordance with claim 1, wherein the step of decompressing (220) includes
terminating the decompressing step when a bit stream is depleted of compressed data (22), and
restarting the decompressing step when the bit stream is full of compressed data (22).

6. A controller (14) configured to receive a compressed data (22) file from a host computer (18), and decompress said compressed data (22) file for use by the controller (14), said controller (14) comprising:
a random access memory (RAM) (24) configured to receive compressed data (22) from the host computer (18) and accumulate uncompressed data as the compressed data (22) is decompressed, wherein an unknown amount of uncompressed data arises from a known amount of compressed data (22);
a flash memory (26) configured to store a block (28) of decompressed data that has accumulated in the RAM (24), and wherein the block (28) has a block size that corresponds to an integer multiple of a minimum modulus size of the flash memory (26); and
a processor (30) configured to
load (205) compressed data (22) received from the host computer (18) into the RAM (24) until a predetermined amount of compressed data (22) is present in the RAM (24), or an end of file of the compressed data (22) file is detected, then
decompress (220) compressed data (22) retrieved from the RAM (24) until a decompressed amount of decompressed data equals the block size, or all compressed data (22) in RAM (24) is decompressed, then
if the decompressed amount of decompressed data equals the block size, transfer (245) the block (28) of decompressed data to the flash memory (26),
if the amount of decompressed data is less than the block size and the end of file has not been detected, repeat the load and decompress steps (205), and
if the amount of decompressed data is less than the block size and the end of file has been detected, transfer (245) the decompressed data to the flash memory (26).
